# EUROPEAN PATENT SPECIFICATION

(11) **EP 3 832 785 B1**
(45) Date of publication and mention of the grant of the patent: **01.05.2024**
(21) Application number: 19841204.1
(22) Date of filing: 29.05.2019
(51) Int. Cl.: H01M 10/6556, H01L 23/473, H01M 10/613, H01M 10/625, H01M 10/6551, H01M 10/6554, H05K 7/20

(54) **COOLER**
KÜHLER
REFROIDISSEUR

(30) Priority: 27.07.2018 JP 2018140899
(43) Date of publication of application: 09.06.2021
(73) Proprietor: Nippon Light Metal Company, Ltd., Tokyo 105-0004 (JP)
(72) Inventor: HIRANO, Yutaka, Shizuoka-shi, Shizuoka 421-3297 (JP); NAKAMURA, Takumi, Tokyo 105-0004 (JP)
(74) Representative: TBK
(86) International application number: PCT/JP2019/021312
(87) International publication number: WO 2020/021848

(56) References cited:
- JP-A- 2018 041 772
- JP-A- 2018 041 772
- US-A1- 2013 068 434

## Description

### Technical Field

The present invention relates to a cooling device for cooling a semiconductor device, a power device such as a battery and an inverter arranged in an electric vehicle or a hybrid vehicle, and so on.

### Background Art

Generally, in vehicles such as electric vehicles and hybrid vehicles, a battery is adopted as a power source for a motor that propels the vehicle.

In order to operate the motor to launch and accelerate the vehicle, and to generate a brake force to stop the vehicle abruptly, a battery having a large capacity is employed.

For these purposes, it is necessary to compulsory cool the battery using a cooling device, so as to prevent a reduction in performance of the battery due to temperature rise.

In the prior art, there is known a cooling device of this kind in which a coolant channel is provided inside a cooling plate (cooling device) arranged at the bottom of the battery (for example, see JP 2010-50000 A). The cooling device of this kind is cooled by vaporization heat of coolant supplied to the coolant channel, and the battery is cooled by transferring heat of the battery to the cooling device thus cooled.

According to one aspect of JP 2010-50000 A, radiator fins are attached to aluminum flat pipe having a plurality of coolant channels extending parallel to one another.

In the cooling device taught by JP 2010-50000 A, the coolant is supplied to the cooling device arranged at a bottom of the battery thereby cooling the battery in which a plurality of battery cells are connected to one another.

JP 2018 041772 A discloses a heat exchanger having a plurality of heat exchange tubes that form a refrigerant flow path for a refrigerant. The heat exchange tubes are configured as a laminated body in which electronic components are arranged in a gap between adjacent heat exchange tubes. The heat exchange tubes are between plates, a first outer plate and a second outer plate. In the flow path of the heat exchange tubes fins are arranged.

US 2013/068434 A1 discloses a heat exchanger that comprises connecting parts, which connect together the adjacent fins among the fins; protrusions formed on the connecting parts; and positioning holes for positioning the fins formed in the housing. The adjacent fins are disposed at predetermined intervals in the coolant flow direction with a predetermined offset amount in the direction that orthogonally intersects the coolant flow direction by fitting the protrusions in the positioning holes.

### Summary of Invention

### Technical Problem to be Solved by the Invention

However, since a thermal boundary layer is created in each clearance between the battery cells due to a temperature difference, a variation in temperature (temperature deviation) is caused on a surface of the cooling device. For this reason, the battery may not be cooled homogeneously and efficiently.

Likewise, for example, the power device such as the inverter, the semiconductor device etc. other than the battery also may not be cooled homogeneously and efficiently due to a variation in surface temperature (temperature deviation).

The present invention has been conceived noting the foregoing technical problems, and it is therefore an object of the present invention to provide a cooling device that cools a heating element such as a battery homogeneously and efficiently, by suppressing a temperature variation on a surface of the cooling device while suppressing an increase in a temperature variation in the heating element.

### Means for Solving the Problem

The above object is solved by a cooling device having the features of claim 1. Further developments are stated in the dependent claims.

According to the above-explained configuration, therefore, positions of the corrugate fins may be fixed by the stoppers protruding from any one of the upper plate and the lower plate, at sites to which heat of a heat generating element such as a battery is transmitted.

According to the present invention, arrays of the pedestals are formed in a staggered manner at predetermined intervals in a direction perpendicular to the flowing direction of the fluid across the corrugate fins, and the stoppers are spaced at sites adjacent to the pedestals.

In this case, the pedestal may be shaped into a substantially circular shape viewed from the top. In addition, one end of the stopper may be situated on a virtual line drawn perpendicular to the corrugate fin from an intersection between: an outer circumference of one of the pedestals formed on one side of the corrugate fin; and a virtual line drawn from a center of said one of the pedestals at 45 degrees with respect to the corrugate fin. On the other hand, other end of the stopper may be situated on a virtual line drawn perpendicular to the corrugate fin from an intersection between: an outer circumference of another one of the pedestals formed on the other side of the corrugate fin; and a virtual line drawn from a center of said another one of the pedestals at 45 degrees with respect to the corrugate fin.

According to the above-explained configuration, therefore, the fluid flowing into the corrugate fin from upstream side may be divided by spaces between the stoppers thereby allowing the fluid to flow through the corrugate fin homogeneously. That is, given that the stoppers are not available, the fluid is not allowed to flow smoothly from upstream to downstream of the pedestal, but allowed to flow smoothly trough a section where the pedestal is not formed. Since the stoppers fixing the positions of the corrugate fins are formed at sites to which the flow of the fluid is oriented, the fluid is allowed to flow homogeneously through the cooling device entirely.

In addition, connecting holes formed on both ends of the fluid passage may serve not only as an inlet hole but also as an outlet hole of the fluid. For this reason, flexibility of installation of the cooling device may be enhanced.

As described, the pedestal may be shaped into a substantially circular shape viewed from the top. In addition, one end of the stopper may be situated on a virtual line drawn perpendicular to the corrugate fin from an intersection between: an outer circumference of one of the pedestals formed on one side of the corrugate fin; and a virtual line drawn from a center of said one of the pedestals at 45 degrees with respect to the corrugate fin. On the other hand, other end of the stopper may be situated on a virtual line drawn perpendicular to the corrugate fin from an intersection between: an outer circumference of another one of the pedestals formed on the other side of the corrugate fin; and a virtual line drawn from a center of said another one of the pedestals at 45 degrees with respect to the corrugate fin. Therefore, the fluid flowing around one of the pedestals is allowed to flow smoothly into the space between the stoppers formed downstream of said one of the pedestals, while being divided homogeneously by the spaces between the stoppers. In addition, the fluid flowing though the corrugate fin is allowed to flow out of the corrugate fin smoothly toward both sides of another one of the pedestals situated downstream of the corrugate fin while being divided homogeneously by the spaces between the stoppers.

In addition, the stoppers may be formed integrally with any one of the upper plate and the lower plate.

According to the above-explained configuration, therefore, the stoppers for positioning the corrugate fins may be formed easily.

### Advantageous Effects of Invention

Since the present invention is configured as has been described, the following advantages may be achieved.
(1) According to claim 1 of the present invention, positions of the corrugate fins may be fixed to a heat generating region of the heat generating element such as a battery by the stoppers projecting from the upper plate or the lower plate. Therefore, temperature variations in the heat generating element such as a battery and the surface of the cooling device may be suppressed so that the heat generating element may be cooled homogeneously and efficiently.
(2) According to claim 2 of the present invention, the fluid flowing into the corrugate fin from upstream side may be divided by spaces between the stoppers thereby allowing the fluid to flow through the corrugate fin homogeneously. Therefore, in addition to the advantage (1), turbulence of the flow of the fluid may be suppressed thereby cooling the heat generating element such as a battery homogeneously and efficiently.
   In addition, the connecting holes formed on both ends of the fluid passage may serve not only as an inlet hole but also as an outlet hole of the fluid. Therefore, flexibility of installation of the cooling device may be enhanced.
(3) According to claim 3 of the present invention, the fluid flowing around one of the pedestals is allowed to flow smoothly into the space between the stoppers formed downstream of said one of the pedestals, and to further flow out of the corrugate fin smoothly toward both sides of another one of the pedestals situated downstream of the corrugate fin while being divided homogeneously by the spaces between the stoppers. Therefore, in addition to the advantages (1) and (2), the flow of the fluid may be further smoothened thereby cooling the heat generating element such as a battery homogeneously and efficiently.
(4) According to claim 4 of the present invention, the stoppers for positioning the corrugate fins may be formed easily. Therefore, in addition to the advantages (1), (2), and (3), number of parts may be reduced and the cooling device may be assembled easily.

### Brief Description of Drawings

[Fig. 1] (a) is a plane view partially showing the cooling device according to the present invention, and (b) is a partially omitted enlarged side view showing the cooling device.
[Fig. 2] (a) is an enlarged cross-sectional view along the I-I line drawn in Fig. 1(a), and (b) is an enlarged cross-sectional view along the II-II line drawn in Fig. 1(b).

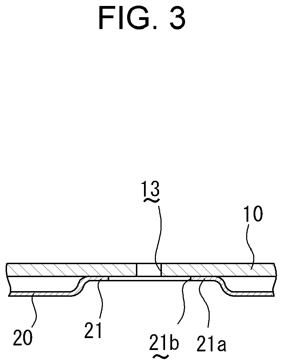

[Fig. 3] is an enlarged cross-sectional view along the III-III line drawn in Fig. 1(a).
[Fig. 4] is an enlarged plane view showing the section IV shown in Fig. 1(a).
[Fig. 4A] is a schematic plane view showing a flow of fluid.
[Fig. 5] (a) is a bottom view showing an upper plate according to the present invention, and (b) is an enlarged cross-sectional view along the V-V line drawn in Fig. 5(a).
[Fig. 6] (a) is a plane view showing a lower plate according to the present invention, and (b) is an enlarged cross-sectional view along the VI-VI line drawn in Fig. 6(a).
[Fig. 7] (a) is a plane view showing a corrugate fin according to the present invention, (b) is a partially omitted enlarged side view showing the corrugate fin shown in Fig. 7(a), and (c) is an enlarged view showing the section VII shown in Fig. 7(b).

### Description of Embodiment(s)

Now, embodiments of the cooling device according to the present invention will be described in detail with reference to the accompanying drawings. Hereinafter, an example of employing the cooling device to cool a heated battery mounted on a vehicle will be explained.

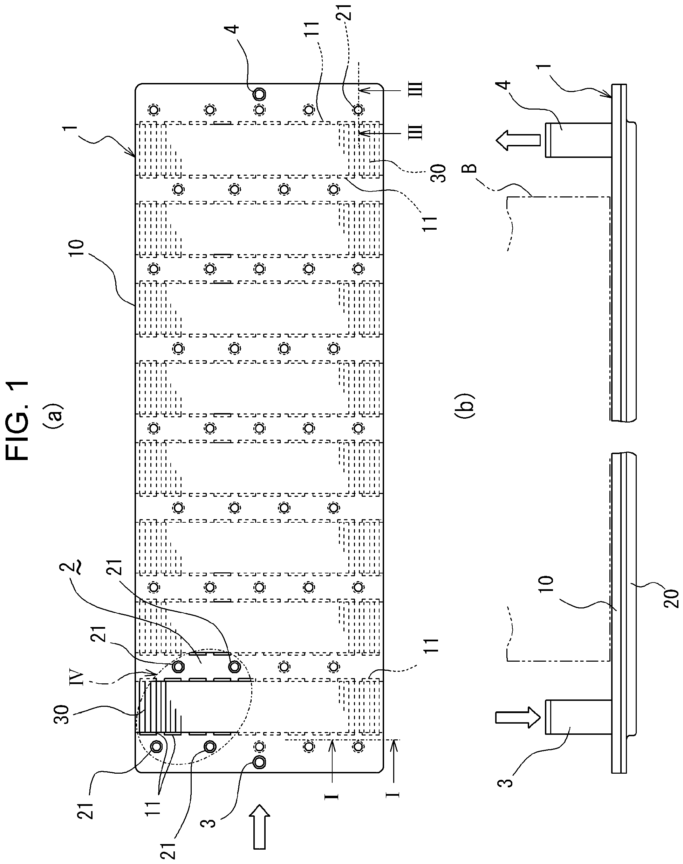

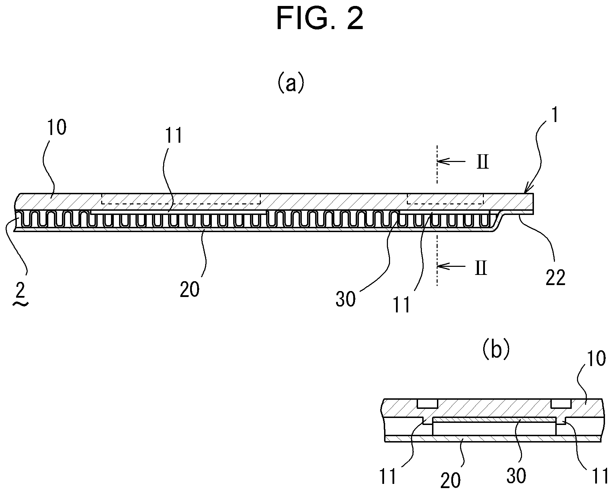

As illustrated in Figs. 1 and 2, the cooling device 1 according to the present invention comprises: an upper plate 10 serving as a heat receiving surface arranged underneath a bottom of the battery B; a lower plate 20 arranged parallel to the upper plate 10 across a fluid passage 2; and a plurality of corrugate fins 30 interposed between the upper plate 10 and the lower plate 20. For example, the battery B is adapted as a power source of a motor to propel the vehicle, and in the battery B, a plurality of battery cells (not shown) are connected to one another. A fluid inlet pipe 3 and a fluid outlet pipe 4 are communicated to the fluid passage 2 at each end of the cooling device 1.

Specifically, the corrugate fins 30 are arranged in a direction perpendicular to a direction of the fluid passage 2 to flow a fluid at predetermined intervals underneath the battery cells (not shown), and both side edges of each of the corrugate fins 30 in the flowing direction of the fluid are supported by stoppers 11 protruding from the upper plate 10.

In addition, the upper plate 10 and the lower plate 20 are joined to each other through pedestals 21 each of which bulges from the lower plate 20, and a peripheral edge of the upper plate 10 and a peripheral edge of the lower plate 20 are joined to each other.

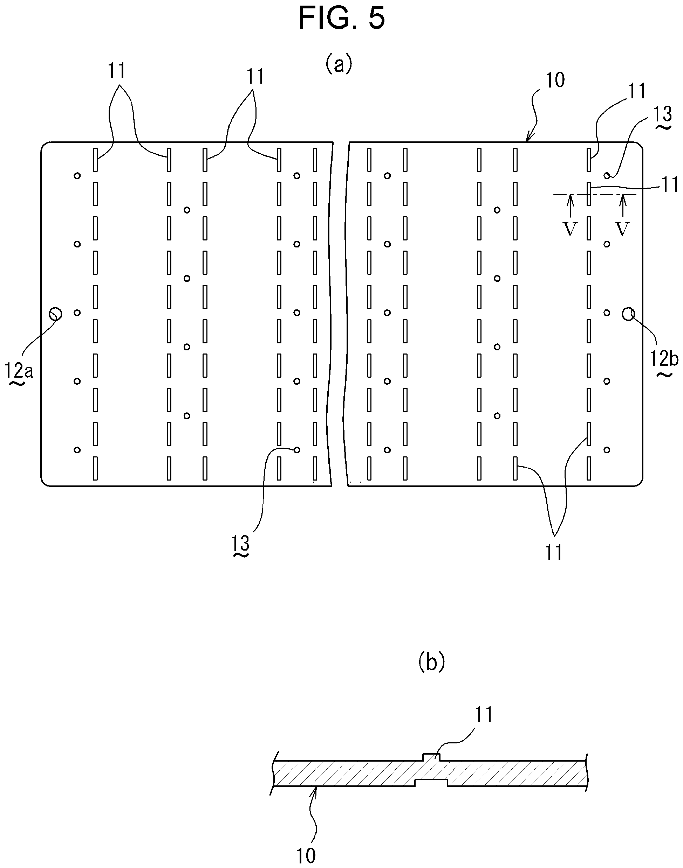

The upper plate 10 is formed of a substantially rectangular aluminum plate material. As illustrated in Figs. 2 and 5, a plurality of arrays of the stoppers 11 protrude from a lower surface of the upper plate 10 at predetermined intervals in the flowing direction of the fluid, so as to support the side edges of each of the corrugate fins 30 in a width (lateral) direction. The stoppers 11 are formed integrally with the upper plate 10 by a press working method (cf., Fig. 5(b)).

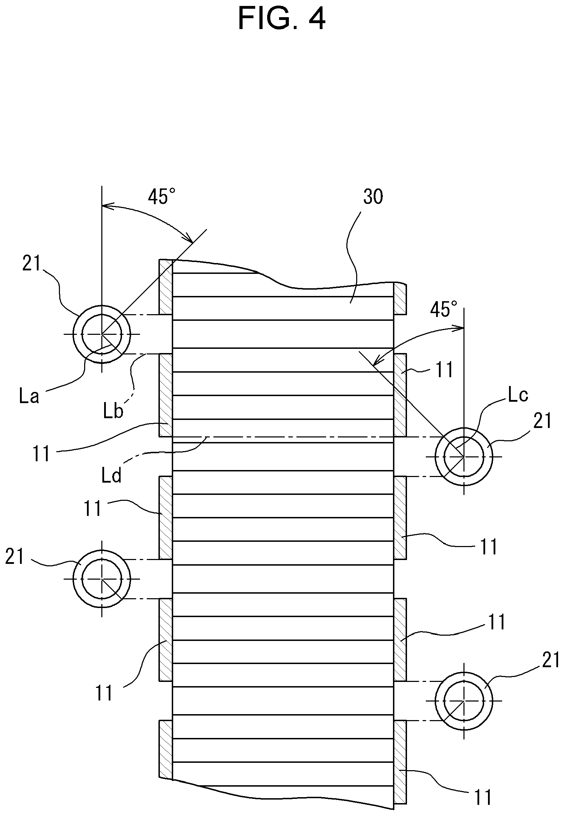

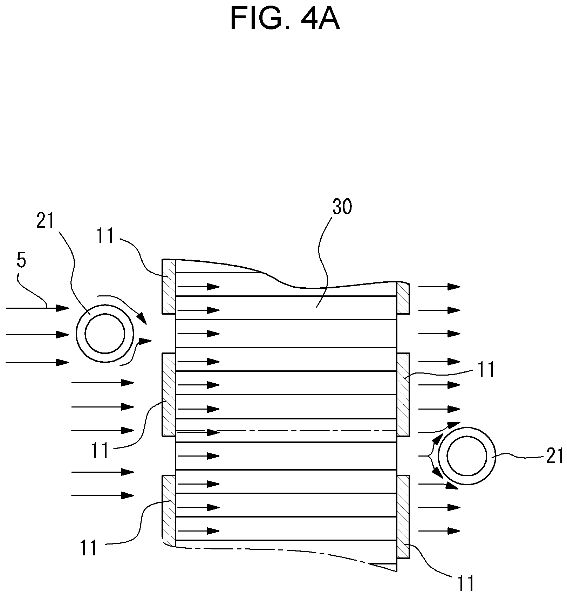

Specifically, in the array of the stoppers 11, the stoppers 11 are spaced at sites adjacent to the pedestals 21 each of which is shaped into a circular shape viewed from the top. In Fig. 4, a virtual line Lb is drawn perpendicular to the corrugate fin 30 from an intersection between: an outer circumference of one of the pedestals 21 formed on one side of the corrugate fin 30; and a virtual line La drawn from a center of said one of the pedestals 21 at 45 degrees with respect to the corrugate fin 30. Likewise, a virtual line Ld is drawn perpendicular to the corrugate fin 30 from an intersection between: an outer circumference of another one of the pedestals 21 formed on the other side of the corrugate fin 30; and a virtual line Lc drawn from a center of said another one of the pedestals 21 at 45 degrees with respect to the corrugate fin 30. In one of the stoppers 11 in the array, one end is situated on the virtual line Lb, and the other end is situated on the virtual line Ld.

Thus, each end of said one of the stoppers 11 is situated on the virtual line Lb and the virtual line Ld, respectively. As described, the virtual line Lb is drawn perpendicular to the corrugate fin 30 from the intersection between: the outer circumference of the pedestal 21 formed on one side of the corrugate fin 30; and the virtual line La drawn from the center of said pedestal 21 at 45 degrees with respect to the corrugate fin 30. On the other hand, the virtual line Ld is drawn perpendicular to the corrugate fin 30 from the intersection between: the outer circumference of the pedestal 21 formed on the other side of the corrugate fin 30; and the virtual line Lc drawn from the center of said pedestal 21 at 45 degrees with respect to the corrugate fin 30. Therefore, as illustrated in Fig. 4A, a fluid 5 flowing around said one of the pedestals 21 is allowed to flow smoothly into the corrugate fin 30 from the space between the stoppers 11 formed downstream of said one of the pedestals 21, and to flow out of the corrugate fin 30 smoothly toward both sides of said another one of the pedestals 21.

Connecting holes 12a and 12b are formed on each end of the upper plate 10 in a longitudinal direction as a flowing direction of the fluid 5, and for example, the fluid inlet pipe 3 and the fluid outlet pipe 4 are connected to the connecting hole 12a and the connecting hole 12b, respectively. In addition, small holes 13 are formed on the upper plate 10 at sites above a center of each of the pedestals 21 to fix the cooling device 1 to the vehicle. According to the embodiment, a thickness of the upper plate 10 is 3 mm, and a vertical length of each of the stoppers 11 is 1 mm. However, those dimensions should not be limited to the above-mentioned values.

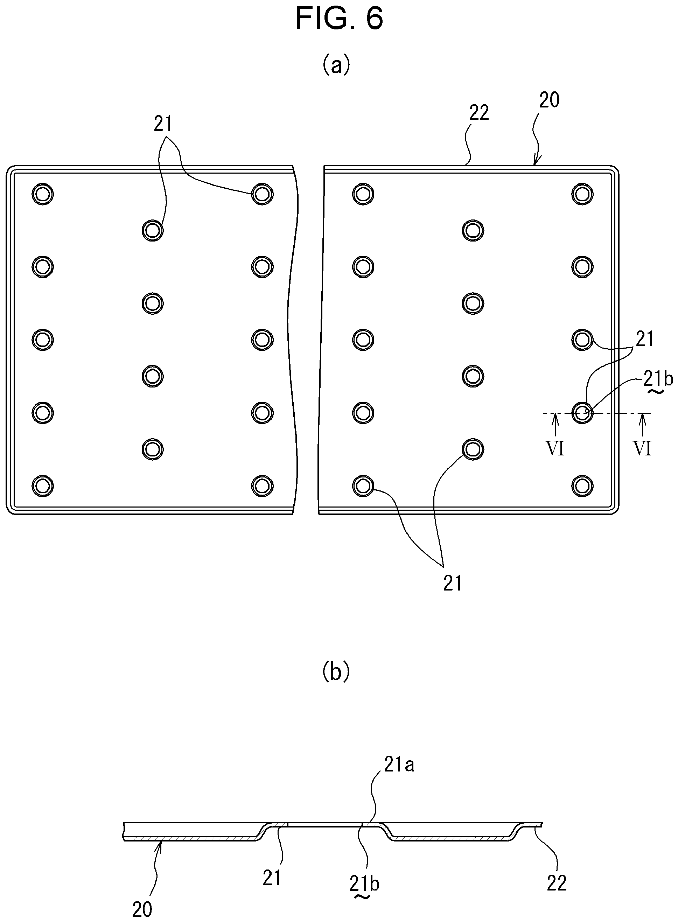

The lower plate 20 is made of aluminum material. As illustrated in Fig. 6, the lower plate 20 is shaped into a flat plate shape, and an outward flange 22 is formed around the peripheral edge of the lower plate 20. On the lower plate 20, a plurality of arrays of the pedestals 21 are formed in a staggered manner, at predetermined intervals in a direction perpendicular to the flowing direction of the fluid 5 across the corrugate fins 30 (specifically, sites on which the corrugate fins 30 are disposed).

The pedestals 21 are formed by pressing a bottom of the lower plate 20 so that each of the pedestals 21 are shaped into a substantially circular shape viewed from the top. An upper flat portion 21a of each of the pedestals 21 is individually aligned with the flange 22 to be contacted to a lower surface of the upper plate 10, and a round hole 21b is formed on a center of the upper flat portion 21a of each of the pedestals 21 to fix the cooling device 1 to the vehicle.

According to the embodiment, a thickness of the lower plate 20 is 1 mm, and a height of each of the pedestals 21 is 3 mm. However, those dimensions should not be limited to the above-mentioned values.

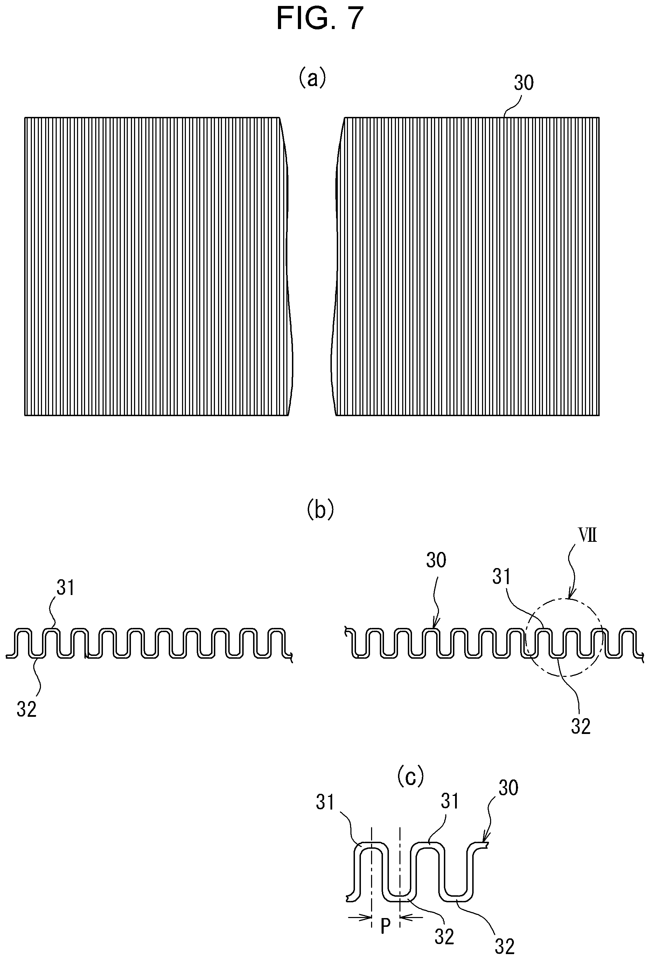

The corrugate fins 30 are formed of aluminum material, and as illustrated in Fig. 7, each of the corrugate fins 30 is individually shaped into a wavy shape in which an upper flat portions 31 and lower flat portions 32 are formed alternately. According to the embodiment, a thickness of each of the corrugate fins 30 is 0.3 mm, each clearance (i.e., a pitch P between the upper flat portion 31 and the lower flat portions 32) is 1.5 mm, and a height is 3 mm. However, those dimensions should not be limited to the above-mentioned values.

Each of the corrugate fins 30 is individually positioned between the upper plate 10 and the lower plate 20, by a pair of arrays of the stoppers 11 projecting from the upper plate 10 to support both long sides of the corrugate fin 30 in the width direction. The upper flat portions 31 are contacted to the lower surface of the upper plate 10, and the lower flat portions 32 are contacted to an upper surface of the lower plate 20.

The upper plate 10, the corrugate fins 30, and the lower plate 20 are brazed to one another. Specifically, the corrugate fins 30 are individually brazed not only to the upper plate 10 but also to the lower plate 20. The pedestals 21 bulging from the lower plate 20 are brazed to the lower surface of the upper plate 10, and the flange 22 of the lower plate 20 is brazed to the peripheral edge of the upper plate 10.

For example, the corrugate fins 30 may be brazed to the upper plate 10 and the lower plate 20 using a brazing sheet in which a surface material layer is overlapped onto a core material layer, or applying brazing material to e.g., the corrugate fins 30.

Although the stoppers 11 project from the lower surface of the upper plate 10 in the foregoing description, the stoppers 11 may also be projected from the upper surface of the lower plate 20. In addition, the pedestals 21 may also be formed by pressing the upper plate 10 downwardly to be contacted to the upper surface of the lower plate 20 as long as a heat receiving area of the upper plate 10 is ensured.

As described, in the cooling device 1 according to the embodiment, positions of the corrugate fins 30 may be fixed to a heat generating region of the battery B by the stoppers 11 projecting from the upper plate 10 or the lower plate 20. Therefore, the temperature variations in the battery B and the surface of the cooling device 1 may be suppressed so that the battery B is cooled homogeneously and efficiently.

In addition, since the positions of the corrugate fins 30 are fixed by the stoppers 11, the corrugate fins 30 may be attached to the upper plate 10 and the lower plate 20 easily and certainly.

As also described, in one of the stoppers 11 in the array, one end is situated on the virtual line Lb drawn perpendicular to the corrugate fin 30 from the intersection between: the outer circumference of one of the pedestals 21 formed on one side of the corrugate fin 30; and the virtual line La drawn from the center of said one of the pedestals 21 at 45 degrees with respect to the corrugate fin 30. On the other hand, the other end of said stopper 11 is situated on the virtual line Ld drawn perpendicular to the corrugate fin 30 from the intersection between: the outer circumference of another one of the pedestals 21 formed on the other side of the corrugate fin 30; and the virtual line Lc drawn from the center of said another one of the pedestals 21 at 45 degrees with respect to the corrugate fin 30. Therefore, as illustrated in Fig. 4A, the fluid 5 flowing around said one of the pedestals 21 is allowed to flow smoothly into the corrugate fin 30 from the space between the stoppers 11 formed downstream of said one of the pedestals 21, while being divided homogeneously by the spaces between the stoppers 11 of the array of upstream of the corrugate fin 30. The fluid 5 flowing though the corrugate fin 30 is allowed to flow out of the corrugate fin 30 smoothly toward both sides of said another one of the pedestals 21 situated downstream of the corrugate fin 30 while being divided homogeneously by the spaces between the stoppers 11 of the array of downstream of the corrugate fin 30. Consequently, the battery B can be cooled homogeneously and efficiently.

As also described, since the arrays of the pedestals 21 are arranged in the staggered manner, the connecting holes 12a and 12b may serve not only as an inlet hole but also as an outlet hole of the fluid 5. For this reason, flexibility of installation of the cooling device 1 may be enhanced.

In addition, since the stoppers 11 for positioning the corrugate fins 30 are formed integrally, number of parts may be reduced and the cooling device 1 may be assembled easily.

In the embodiment thus has been described, the cooling device according to the present invention is adapted to remove the heat generated by the battery B serving as the power source of the motor for propelling the vehicle. However, application of the cooling device according to the present invention should not limited to the foregoing embodiment, and for example, the cooling device according to the present invention may also be adapted to cool a power device such as an inverter or a semiconductor element.

### Examples

Here will be described a comparative result between a variation in a surface temperature of the cooling device according to the present invention (Examples 1, 2) and a variation in a surface temperature of a cooling device without having the stoppers 11 (Comparative examples 1, 2).
<Specimens>
   ▪ Corrugate fin
      Thickness: 0.3 mm, Clearance (pitch between the upper flat portion and the lower flat portions): 1.5 mm, Length: 100 mm.
   ▪ Stopper
      Vertical length: 1 mm, Width: 2 mm.
   ▪ Heat generating area
      Amount of heat generation: 360 W▪2.
<Physical Property Value of Fluid>
   ▪ Density: 1038 kg/m³.
   ▪ Viscosity: 0.00128 Pa▪s
   ▪ Specific heat: 3482 J/(kgK).
   ▪ Heat conductivity: 0.424 W/(mK).

The cooling device was thermally insulated entirely therearound, and the comparative result was analyzed on the assumption that the heat generating area was cooled only by a heat exchange between the corrugate fin and the fluid. The variations in the surface temperature was analyzed using ANSYS Icepak R18.1.

In the above condition, (The Comparative example 1 and the Example 1) were executed while flowing the fluid at a rate of 10 L/min, and (the Comparative example 2 and the Example 2) were executed while flowing the fluid at a rate of 20 L/min. A difference between a surface temperature of the cooling device and a temperature of the fluid at an inlet in each example is shown in table 1, and performances of the cooling devices in each example estimated from the analysis are shown in table 2.

**[TABLE 1]**

| CLEARANCE (mm) | THICKNESS OF FIN (mm) | LENGTH OF FIN (mm) | FLOW RATE (L/min) | STOPPERS | PRESSURE LOSS (kPa) | DIFFERENCE BETWEEN SURFACE TEMPERATURE OF COOLING PLATE AND TEMPERATURE OF FLUID AT INLET (°C) | | | | | | | |
|---|---|---|---|---|---|---|---|---|---|---|---|---|---|
| | | | | | | HEAT GENERATING AREA 1 (INLET SIDE) | | | | HEAT GENERATING AREA 2 (OUTLET SIDE) | | | |
| | | | | | | min | max | ave | max-min | min | max | ave | max-min |
| 1.5 | 0.3 | 100 | 10 | NONE (COMPARATIVE EXAMPLE 1) | 0.34 | 0.97 | 3.11 | 1. 67 | Z 13 | 1.69 | 3. 61 | 2.45 | 1.92 |
| | | | | FORMED INTERMITTENTLY ON BOTH SIDES (EXAMPLE 1) | 0.37 | 0.90 | 2.87 | 1.58 | 1.97 | 1. 55 | 3.33 | 2.30 | 1.78 |
| | | | 20 | NONE (COMPARATIVE EXAMPLE 2) | 0.77 | 0.72 | 2. 39 | 1.26 | 1.68 | 1.08 | 2. 64 | 1.71 | 1.56 |
| | | | | FORMED INTERMITTENTLY ON BOTH SIDES (EXAMPLE 2) | 0.88 | 0.67 | 2.15 | 1.17 | 1.49 | 0.97 | 2.39 | 1.58 | 1.42 |

**[TABLE 2]**

| FLOW RATE (L/m i n) | STOPPERS | PRESSURE LOSS (kPa) | VARIATION IN SURFACE TEMPERATURE (°C) |
|---|---|---|---|
| 10 | NONE (COMPARATIVE EXAMPLE 1) | 1.36 | 6.22 |
| | FORMED INTERMITTENTLY ON BOTH SIDES (EXAMPLE 1) | 1.50 | 6.01 |
| 20 | NONE (COMPARATIVE EXAMPLE 2) | 6. 13 | 6. 11 |
| | FORMED INTERMITTENTLY ON BOTH SIDES (EXAMPLE 2) | 7. 03 | 5. 90 |

As can be seen from the analysis results, a pressure loss in the cooling device having the stoppers were slightly increased according to the Examples 1 and 2, compared to those of the cooling device without having the stoppers according to Comparative Examples 1 and 2. However, in the case of flowing the fluid at the rate of 10 L/min, a variation in the surface temperature (temperature deviation) according to the Example 1 was 6.01 degrees C, while a variation in the surface temperature (temperature deviation) according to the Comparative Example 1 was 6.22 degrees C. Likewise, in the case of flowing the fluid at the rate of 20 L/min, a variation in the surface temperature (temperature deviation) according to the Example 2 was 5.90 degrees C, while a variation in the surface temperature (temperature deviation) according to the Comparative Example 2 was 6.11 degrees C.

In conclusion, it was found that the variation in the surface temperature can be suppressed by arranging the stoppers 11 intermittently.

## Claims

1. A cooling device (1) comprising:
an upper plate (10) serving as a heat receiving surface;
a lower plate (20) arranged parallel to the upper plate (10) across a fluid passage; and
a corrugate fin (30) interposed between the upper plate (10) and the lower plate (20),
wherein
a plurality of the corrugate fins (30) are arranged perpendicular to the fluid passage at predetermined intervals in a flowing direction of a fluid, and both side edges of each of the corrugate fins (30) in the flowing direction of the fluid are supported by stoppers (11) protruding from any one of the upper plate (10) and the lower plate (20);
the upper plate (10) and the lower plate (20) are joined to each other through pedestals (21) each of which bulges from any one of the upper plate (10) and the lower plate (20) to be fixed to the other one of the upper plate (10) and the lower plate (20), and a peripheral edge of the upper plate (10) and a peripheral edge of the lower plate (20) are joined to each other; and
arrays of the pedestals (21) are formed in a staggered manner at predetermined intervals in a direction perpendicular to the flowing direction of the fluid across the corrugate fins (30), and
the stoppers (11) are spaced at sites adjacent to the pedestals (21).

2. The cooling device (1) as claimed in claim 1, wherein
the pedestal (21) is shaped into a substantially circular shape viewed from the top,
one end of the stopper (11) is situated on a virtual line drawn perpendicular to the corrugate fin (30) from an intersection between: an outer circumference of one of the pedestals (21) formed on one side of the corrugate fin (30); and a virtual line drawn from a center of said one of the pedestals (21) at 45 degrees with respect to the corrugate fin (30), and
other end of the stopper (11) is situated on a virtual line drawn perpendicular to the corrugate fin (30) from an intersection between: an outer circumference of another one of the pedestals (21) formed on the other side of the corrugate fin (30); and a virtual line drawn from a center of said another one of the pedestals (21) at 45 degrees with respect to the corrugate fin (30).

3. The cooling device (1) as claimed in any one of claims 1 or 2, wherein the stoppers (11) are formed integrally with any one of the upper plate (10) and the lower plate (20).

## Patentansprüche

1. Kühlvorrichtung (1) mit:
einer oberen Platte (10), die als eine Wärmeempfangfläche dient;
einer unteren Platte (20), die parallel zu der oberen Platte (10) quer über einen Fluidkanal angeordnet ist; und
einer Wellenrippe (30), die zwischen der oberen Platte (10) und der unteren Platte (20) angeordnet ist,
wobei
eine Vielzahl der Wellenrippen (30) senkrecht zu dem Fluidkanal unter vorbestimmten Abständen in einer Strömungsrichtung eines Fluides angeordnet sind, und beide Seitenränder von jeder der Wellenrippen (30) in der Strömungsrichtung des Fluides durch Stopper (11) gestützt sind, die von einer Beliebigen aus der oberen Platte (10) und der unteren Platte (20) vorragen;
die obere Platte (10) und die untere Platte (20) miteinander durch Sockel (21) verbunden sind, von denen jeder von irgendeiner aus der oberen Platte (10) und der unteren Platte (20) ausbaucht, um mit der anderen aus der oberen Platte (10) und der unteren Platte (20) fixiert zu werden, und ein Umfangsrand der oberen Platte (10) und ein Umfangsrand der unteren Platte (20) miteinander verbunden sind; und
Aufreihungen der Sockel (21) in einer versetzten Weise unter vorbestimmten Abständen in einer Richtung ausgebildet sind, die senkrecht zu der Strömungsrichtung des Fluides quer über die Wellenrippen (30) ist, und
die Stopper (11) an Orten beabstandet sind, die benachbart zu den Sockeln (21) sind.

2. Kühlvorrichtung (1) gemäß Anspruch 1, wobei
unter Betrachtung von oben der Sockel (21) zu einer im Wesentlichen kreisartigen Form geformt ist,
ein Ende des Stoppers (11) auf einer virtuellen Linie angeordnet ist, die senkrecht gezogen ist zu der Wellenrippe (30) von einem Schnittpunkt zwischen: einem Außenumfang von einem der Sockel (21), die an einer Seite der Wellenrippe (30) ausgebildet sind; und einer virtuellen Linie, die von einer Mitte des einen der Sockel (21) unter 45 Grad in Bezug auf die Wellenrippe (30) gezogen ist, und
ein anderes Ende des Stoppers (11) auf einer virtuellen Linie angeordnet ist, die senkrecht gezogen ist zu der Wellenrippe (30) von einem Schnittpunkt zwischen: einem Außenumfang eines anderen der Sockel (21), die an der anderen Seite der Wellenrippe (30) ausgebildet sind; und einer virtuellen Linie, die von einer Mitte des anderen der Sockel (21) unter 45 Grad in Bezug auf die Wellenrippe (30) gezogen ist.

3. Kühlvorrichtung (1) gemäß einem der Ansprüche 1 oder 2, wobei die Stopper (11) einstückig mit einer aus der oberen Platte (10) und der unteren Platte (20) ausgebildet sind.

## Revendications

1. Dispositif de refroidissement (1) comprenant :
une plaque supérieure (10) servant de surface de réception de la chaleur ;
une plaque inférieure (20) disposée parallèlement à la plaque supérieure (10) à travers un passage de fluide ; et
une ailette ondulée (30) interposée entre la plaque supérieure (10) et la plaque inférieure (20),
dans lequel
une pluralité d'ailettes ondulées (30) sont disposées perpendiculairement au passage du fluide à des intervalles prédéterminés dans une direction d'écoulement d'un fluide, et les deux bords latéraux de chacune des ailettes ondulées (30) dans la direction d'écoulement du fluide sont soutenus par des arrêts (11) faisant saillie de l'une quelconque de la plaque supérieure (10) et de la plaque inférieure (20) ;
la plaque supérieure (10) et la plaque inférieure (20) sont reliées l'une à l'autre par des piédestaux (21) dont chacun dépasse de l'une quelconque de la plaque supérieure (10) et de la plaque inférieure (20) pour être fixé à l'autre de la plaque supérieure (10) et de la plaque inférieure (20), et un bord périphérique de la plaque supérieure (10) et un bord périphérique de la plaque inférieure (20) sont reliés l'un à l'autre ; et
des séries de piédestaux (21) sont formés en quinconce à des intervalles prédéterminés dans une direction perpendiculaire à la direction d'écoulement du fluide à travers les ailettes ondulées (30), et
les arrêts (11) sont espacés sur des sites adjacents aux piédestaux (21).

2. Dispositif de refroidissement (1) selon la revendication 1, dans lequel
le piédestal (21) a une forme sensiblement circulaire vue du dessus,
une extrémité du arrêt (11) est située sur une ligne virtuelle tracée perpendiculairement à l'ailette ondulée (30) à partir d'une intersection entre : une circonférence extérieure de l'un des piédestaux (21) formé sur un côté de l'ailette ondulée (30) ; et une ligne virtuelle tracée à partir d'un centre dudit piédestal (21) à 45 degrés par rapport à l'ailette ondulée (30), et
l'autre extrémité du arrêt (11) est située sur une ligne virtuelle tracée perpendiculairement à l'ailette ondulée (30) à partir d'une intersection entre : une circonférence extérieure d'un autre des piédestaux (21) formé sur l'autre côté de l'ailette ondulée (30) ; et une ligne virtuelle tracée à partir d'un centre dudit autre des piédestaux (21) à 45 degrés par rapport à l'ailette ondulée (30).

3. Dispositif de refroidissement (1) selon l'une quelconque des revendications 1 ou 2, dans lequel les arrêts (11) sont formées intégralement avec l'une quelconque de la plaque supérieure (10) et de la plaque inférieure (20).
